Europäisches Patentamt

European Patent Office

Office européen des brevets

(11) Publication number: **0 324 220**
**A1**

## (12) EUROPEAN PATENT APPLICATION

(21) Application number: **88308470.9**

(22) Date of filing: **14.09.88**

(51) Int. Cl.⁴: **H01L 39/12 , H01L 39/24**

(30) Priority: **23.12.87 GB 8730063**

(43) Date of publication of application:
**19.07.89 Bulletin 89/29**

(84) Designated Contracting States:
**DE FR GB IT NL**

(71) Applicant: **PLESSEY OVERSEAS LIMITED**
**Vicarage Lane**
**Ilford Essex IGI 4AQ(GB)**

(72) Inventor: **Dorey, Lynn Yvette**
**36 Annesley Close**
**Langlands Northampton, NN3 3HD(GB)**
Inventor: **Wort, Christopher John**
**1 Valley End Pattishall**
**Towcester Northampton, NN12 8NY(GB)**

(74) Representative: **Lupton, Frederick**
**The Plessey Company plc Intellectual**
**Property Dept. Vicarage Lane**
**Ilford, Essex IG1 4AQ(GB)**

(54) **Superconducting thin films.**

(57) A method of preparing $Y_1Ba_2Cu_3O_{7-\delta}$ superconducting thin films with controlled crystallite orientation onto a variety of substrates is described. A thin (< 1000Å) buffer layer of oriented polycrystalline $SrTiO_3$ is deposited by RF Magnetron Sputtering onto the desired substrate to form simultaneously a diffusion barrier (between the substrate and $Y_1Ba_2Cu_3O_{7-\delta}$) and a lattice-matched, preferred orientation layer for the polycrystalline epitaxy of the $Y_1Ba_2Cu_3O_{7-\delta}$ thin film.

EP 0 324 220 A1

# SUPERCONDUCTING THIN FILMS

This invention relates to superconducting ceramics materials in the form of thin films.

A superconducting ceramics material which is currently of interest is $Y_1Ba_2Cu_3O_{7-\delta}$. The superconducting properties of high Tc thin film $Y_1Ba_2Cu_3O_{7-\delta}$ are highly dependent on the substrate used. Polycrystalline epitaxial $Y_1Ba_2Cu_3O_{7-\delta}$ deposited onto single crystal lattice matched $SrTiO_3$ can, under certain deposition conditions, be c-axis oriented, exhibiting high current carrying capacity (current densities ~ 107 $Acm^{-2}$) and sharp resistive superconducting transitions (with Tc = 87-90K) comparable with high quality ceramic $Y_1Ba_2Cu_3O_{7-\delta}$ results. However, on all other substrates reduced critical current densities, greater resistive tails, and in certain cases reduced Tc onset are seen.

The problem is attributed to:-

(1) diffusion of substrate material into the $Y_1Ba_2Cu_3O_{7-\delta}$ film at the grain boundaries, causing 2nd phase insulating YBC material to be formed at the grain boundaries (particularly serious for Al and Si containing substrates).

(2) non orientation of the deposited film.

Buffer layers of MgO, $Ta_2O_5$, $LaF_3$ or $ZrO_2$ (which all have a high melting point) deposited between Al or Si containing substrates and the $Y_1Ba_2Cu_3O_{7-\delta}$ thin film, can reduce the diffusion of these species, with best results for the high melting point $ZrO_2$ buffer layer. However the $Y_1Ba_2Cu_3O_{7-\delta}$ film cannot be oriented in terms of its lattice structure on such buffer layers.

Vastly improved results are found for oriented polycrystalline $Y_1Ba_2Cu_3O_{7-\delta}$ which is deposited onto a single crystal $SrTiO_3$ substrate ($Y_1Ba_2Cu_3O_{7-\delta}$ orthorhombic: $a_0$ = 3.82Å, $b_0$ = 3.89Å, $c_0$ = 3 x 3.89Å) is lattice matched to $SrTiO_3$ (cubic; $a_0$ = 3.90Å). Such $SrTiO_3$ single crystal substrates are expensive and can only be produced with a small cross-section. This limits the applications of such thin films.

In order to overcome these problems, the present invention provides a superconducting structure comprising a superconducting ceramics film formed on a substrate wherein a buffer layer is provided between the film and the substrate which is non-reactive with the substrate and which has a lattice structure such as to enable a preferred orientation to be produced within the lattice structure of the subsequently deposited superconducting film.

The invention allows the formation or oriented thin films on $Y_1Ba_2Cu_3O_{7-\delta}$ non-compatible substrates such as Si and Al or substrates containing these species, by the deposition of a thin buffer layer of preferred orientation polycrystalline $SrTiO_3$ (a lattice match to $Y_1Ba_2Cu_3O_{7-\delta}$) onto the substrate. The $SrTiO_3$ thin film, typically <1000Å thick, is obtained by RF magnetron sputtering from a ceramic $SrTiO_3$ target onto a heated substrate. The grain size and degree of preferred orientation of the $SrTiO_3$ can be altered by variation of the sputtering conditions, substrate temperature and, if necessary, a post-deposition anneal.

The major advantages are:-

(1) Oriented thin films can be obtained over large areas.

(2) Oriented thin films can be obtained on non-compatible substrates such as Si, Al, Fe or compounds containing Fe, Si or Al.

(3) The orientated $Y_1Ba_2Cu_3O_{7-\delta}$ film crystallinity, grain size and orientation can be tailored to device applications by growing on a suitably prepared $SrTiO_3$ orientated surface.

(4) The $Y_1Ba_2Cu_3O_{7-\delta}$ crystallinity mimics the underlying $SrTiO_3$ substrate texture.

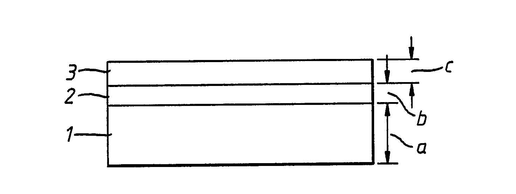

A preferred embodiment of the invention will now be described with reference to the accompanying drawing which is a diagram of the geometry of the superconducting structure according to the invention.

Referring to the drawing, a thin film of $SrTiO_3$ (2) of thickness b is sputtered (RF or RF magnetron) in an Ar/O2 atmosphere from a single watercooled ceramic target of composition $SrTiO_3$ onto the required substrate (1) of thickness a. The substrate is mounted on a substrate heater to obtain the substrate surface temperature required for preferential crystal orientation to be achieved. A negative substrate bias can be applied to decrease negative ion resputtering, alter crystal orientation and improve film adhesion. After deposition an anneal in an $O_2$ atmosphere may be carried out to further increase the grain size.

After the above preparation of the substrate a thin film of $Y_1Ba_2Cu_3O_{7-\delta}$ (3) of thickness c can be deposited onto the $SrTiO_3$ thin film (2) (for instance by ion beam sputtering, magnetron sputtering, e-beam evaporation or molecular beam epitaxy).

Typical deposition conditions are given in Table 1.

Table 1

| Typical Deposition Conditions | | |
|---|---|---|
| Deposition of $SrTiO_3$. | | |
| Pressure<br>Substrate temperature<br>RF Power<br>DC Bias<br>Atmosphere | | 1 - 20 mtorr<br>500 - 1000°C<br>100 - 400W<br>300 - 800V<br>Argon with up to 40% oxygen. |
| Post-deposition anneal | | |
| Temperature<br>Atmosphere | oxygen | 750° - 1400°C |

Variations may be made to the above described embodiment without departing from the invention claimed. Thus preferred orientation polycrystalline $SrTiO_3$ could be used as a buffer layer between a non-compatible substrate and any superconducting thin film compositions in the Y:B:C:0 system.

A magnetic film could be applied behind the substrate during the deposition of $SrTiO_3$ to alter the degree of preferred orientation.


## Claims

1. A superconducting structure comprising a superconducting ceramics film formed on a substrate wherein a buffer layer is provided between the film and the substrate which is non-reactive with the substrate and which has a lattice structure such as to enable a preferred orientation to be produced within the lattice structure of the subsequently deposited superconducting film.

2. A structure as claimed in claim 1 wherein the substrate is a semiconducting substrate or contains silicon or aluminium or iron.

3. A structure as claimed in claim 1 or 2 wherein the superconducting film has the composition $A_aB_bCu_cD_d$, where A is any rare earth, B is an element selected from group IIa of the periodic table, and D is an element selected from period II of the periodic table.

4. A structure as claimed in claim 3 wherein A is yttrium, erbium, holmium, dysprosium or lanthanum, and/or B is barium, calcium or stointium, and/or D is oxygen, nitrogen of fluorine.

5. A structure as claimed in claim 4 wherein the superconducting film is yttrium barium copper oxide.

6. A structure as claimed in claim 5 wherein the film has the stoichiometric ratio $Y_1Ba_2Cu_3O_{7-\delta}$.

7. A structure as claimed in claim 1 or 2 wherein the superconducting film has a perovskite lattice structure.

8. A structure as claimed in claim 7 wherein the buffer layer has a perovskite lattice structure.

9. A structure as claimed in claim 8 wherein the buffer layer comprises $SrTiO_3$.

10. A structure as claimed in claim 1 wherein the buffer layer is applied by a sputtering technique.

11. A structure as claimed in claim 10 wherein the buffer layer is applied by an RF magnetron sputtering technique.

12. A structure as claimed in claim 10 wherein both the buffer layer and the superconducting film are applied by an ion beam sputtering technique.

13. A structure as claimed in any of claims 10 to 12 wherein the buffer layer is annealed.

14. A structure as claimed in any of claims 10 to 13 wherein a magnetic field is applied to the buffer layer during deposition.

15. A structure as claimed in claim 1 and substantially as described herein with reference to the accompanying drawing.

European Patent Office

EUROPEAN SEARCH REPORT

Application Number

EP 88 30 8470

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | APPLIED PHYSICS LETTERS, vol. 51, no. 13, 28th September 1987, pages 1027-1029, American Institute of Physics, New York, US; M. GURVITCH et al.: "Preparation and substrate reactions of superconducting Y-Ba-Cu-O films" <br> * Abstract; page 1027, column 1, paragraph 2 * <br> --- | 1-7,10-11,15 | H 01 L 39/12 <br> H 01 L 39/24 |
| X | APPLIED PHYSICS LETTERS, vol. 51, no. 11, 14th September 1987, pages 852-854, American Institute of Physics, New York, US; B.Oh.M. NAITO et al.: "Critical current densities and transport in super conducting YBa2Cu3O(7-d) films made by electron beam coevaporation" <br> * Abstract; page 852, column 2, paragraph 1 * <br> --- | 1-7 | |
| A | ADVANCED CERAMIC MATERIALS- SUPERCONDUCTORS, vol. 2, no. 3B, July 1987, pages 430-435, ACERS, Westerville, Oh, US; P.H. KOBRIN et al.: "Superconducting oxide thin films by ion beam sputtering" <br> * Page 430, paragraph 4; page 431, paragraphs 4-5 * <br> ----- | 1,3-7,9-10 | **TECHNICAL FIELDS SEARCHED (Int. Cl.4)** <br><br> H 01 L 39 <br> C 01 G 3 |

The present search report has been drawn up for all claims

| Place of search | Date of completion of the search | Examiner |
|---|---|---|
| THE HAGUE | 20-04-1989 | HAMMEL E.J. |

EPO FORM 1503 03.82 (P0401)